(19) Europäisches Patentamt
European Patent Office
Office européen des brevets

(11) **EP 1 256 847 B1**

(12) **EUROPEAN PATENT SPECIFICATION**

(45) Date of publication and mention
of the grant of the patent:
**25.07.2007 Bulletin 2007/30**

(51) Int Cl.:
***G03F 7/20*** (2006.01)

(21) Application number: **02253174.3**

(22) Date of filing: **07.05.2002**

(54) **Lithographic apparatus with purge gas system**

Lithographischer Apparat mit Spülgassystem

Appareil lithographique avec système de purge par gaz

(84) Designated Contracting States:
**DE FR GB IT NL**

(30) Priority: **09.05.2001 EP 01304164**

(43) Date of publication of application:
**13.11.2002 Bulletin 2002/46**

(73) Proprietor: **ASML Netherlands B.V.**
**5504 DR Veldhoven (NL)**

(72) Inventors:
• **Schrijver, Raymond Laurentius Johannes**
**5651 CE Eindhoven (NL)**

• **Van Empel, Tjarko Adriaan Rudolf**
**5643 SC Eindhoven (NL)**
• **Baggen, Marcel Koenraad Marie**
**5671 AR Nuenen (NL)**

(74) Representative: **Leeming, John Gerard**
**J.A. Kemp & Co.,**
**14 South Square,**
**Gray's Inn**
**London WC1R 5JJ (GB)**

(56) References cited:
**EP-A- 0 532 968**       **EP-A- 1 052 551**
**WO-A-99/57607**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The present invention relates to a lithographic projection apparatus comprising :

- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and a first compartment at least partially enclosing and moving with a moveable component of said apparatus.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.

- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus commonly referred to as a step-and-scan apparatus each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens".

Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In a lithographic apparatus, it is common to purge the beam path and the vicinity of the mask and substrate to provide a controlled atmosphere, the aim being to prevent contamination of the mask and substrate and scattering of the projection beam by dust particles and also to provide a constant and consistent atmosphere for interferometric measuring devices which measure the position of the substrate and mask tables. Where the projection beam is of a short wavelength, for example 157nm or 126nm, having a relatively high absorption in air, the gas used for the purge may be nitrogen of high purity. Suitable compositions of such a purge gas are disclosed in EP-1 172 698-A, which document is considered as belonging to the prior art in Europe according to Article 54(3) EPC. Apparatus using nitrogen to purge the beam path and mask or substrate stages are particularly sensitive to leakage of air into the controlled atmosphere since this will result in a change in refractive index, disturbing the interferometric sensors.

In some arrangement using gases to control contamination, nested compartments may be provided with the innermost compartment containing the component to be protected at a higher pressure, for example WO 99/57607. This ensures that any leakage is away from the component to be protected. Conversely, in vacuum systems, it is known to have sealing arrangements with a series of compartments with the inner compartment at lower pressures, see for example EP-1 052 551-A2 and EP-0 532 968-A1. This reduces the pressure differentiates across, and hence forces on, vulnerable parts of the vacuum compartment, e.g. windows.

To reduce the consumption of purge gas, which is expensive due to its purity, in particular in scanners, it has been proposed to provide compartments around the mask and/or substrate tables which move with the respective table as the table scans. This avoids the need to purge a larger compartment encompassing the entire range of movement of the table. Such moveable purge compartments are disclosed in EP-1 098 225-A, which document is considered as belonging to the prior art in Europe according to Article 54(3) EPC. To prevent contamination by leaks of external air into the purge compartment, the purge compartment is maintained at slight over-pressure, e.g. of a few Pa, relative to the remainder of the apparatus.

However, in a scanner, the mask and substrate tables are moved at high velocities and with high accelerations. During both accelerations and constant velocity movement, the pressure within a moving purge chamber is not uniform or constant. In particular, at the leading edge of the chamber significant pressure drops can occur leading to this part of the purge compartment being at a lower pressure than the rest of the apparatus so that inward leaks are possible. Conversely, the pressure at the trailing edge can rise substantially leading to increased leakage of purge gas into the vicinity of the beam paths of the interferometric measuring devices disturbing the reflective index there.

It is an object of the present invention to provide a moveable purge compartment in which inward and/or outward leakage is avoided or reduced even when the purge compartment is undergoing large accelerations or moving at high velocity.

This and other objects are achieved according to the invention in a lithographic projection apparatus comprising:

- a radiation system for providing a projection beam of radiation;
- a support structure for supporting patterning means, the patterning means serving to pattern the projection beam according to a desired pattern;

- a substrate table for holding a substrate;
- a projection system for projecting the patterned beam onto a target portion of the substrate; and a first compartment containing and arranged to move with a moveable component of said apparatus, said first compartment enclosing said movable component in at least a plane containing a direction of movement of said moveable component.

characterized by:

a second compartment containing and arranged to move with said first compartment, said second compartment enclosing said first compartment in at least a plane containing the direction of movement of said moveable component; and
a purge gas system for supplying purge gas to said first compartment and removing purge gas from said second compartment such that said first compartment is, in use, at an average pressure $P_1$, said second compartment is, in use, at an average pressure $P_2$, whereby the pressures $P_1$, $P_2$ satisfy the inequalities:
$P_1 > P_0$ and $P_2 < P_0$

where $P_0$ is the pressure of the environment exterior to the second compartment.

Even when acceleration of the moveable object and compartments cause local pressure variations, the first or inner compartment is at a higher pressure than the second or outer compartment so that any gas flow is outward and contamination is prevented from reaching the inner compartment. Also, the second compartment can be maintained at a lower pressure than the remainder of the apparatus, particularly the beam paths of any interferometric displacement measuring devices, so that leakage of purge gas to disturb these devices is minimized.

Preferably, the depth of the second compartment is substantially equal to that of the first compartment so that pressure variations caused by movements are the same in the two compartments. Isolation of the inner compartment can be further improved by providing a plurality of second compartments nested about the first compartment. In such an arrangement, the pressure of the outermost second compartment is preferably lowest. According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; providing a first compartment containing and arranged to move with a moveable component of said apparatus, said first compartment enclosing said movable component in at least a plane containing a direction of movement of said moveable component.

characterized by:

a second compartment containing and arranged to move with said first compartment, said second compartment enclosing said first compartment in at least a plane containing the direction of movement of said moveable component; and
supplying purge gas to said first compartment and removing purge gas from said second compartment such that said first compartment is at an average pressure $P_1$ and said second compartment is at an average pressure $P_2$; whereby said pressures $P_1$, $P_2$ satisfy the inequalities

$$P_1 > P_0 \text{ and } P_2 < P_0$$

where $P_0$ is the average pressure of the environment exterior to said second compartment.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2 shows pressure levels in and around a purge compartment according to the present invention at rest;
Figure 3 shows pressure levels in and around a purge compartment according to the present invention whilst undergoing acceleration; and

Figure 4 is a cross-section of the mask stage of the apparatus of Figure 1.

In the Figures, corresponding reference symbols indicate corresponding parts.

Embodiment 1

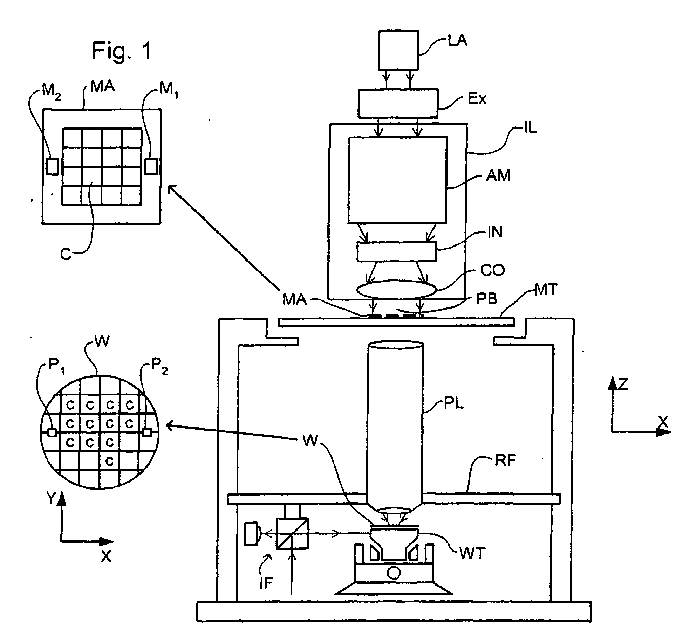

Figure 1 schematically depicts a lithographic projection apparatus according to a particular embodiment of the invention. The apparatus comprises:

a radiation system Ex, IL, for supplying a projection beam PB of radiation (*e.g.* UV radiation of 157nm or 126nm). In this particular case, the radiation system also comprises a radiation source LA;

- a first object table (mask table) MT provided with a mask holder for holding a mask MA (*e.g.* a reticle), and connected to first positioning means for accurately positioning the mask with respect to item PL;
- a second object table (substrate table) WT provided with a substrate holder for holding a substrate W (*e.g.* a resist-coated silicon wafer), and connected to second positioning means for accurately positioning the substrate with respect to item PL;
- a projection system ("lens") PL (*e.g.* a refractive lens system) for imaging an irradiated portion of the mask MA onto a target portion C (*e.g.* comprising one or more dies) of the substrate W.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed $v$, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

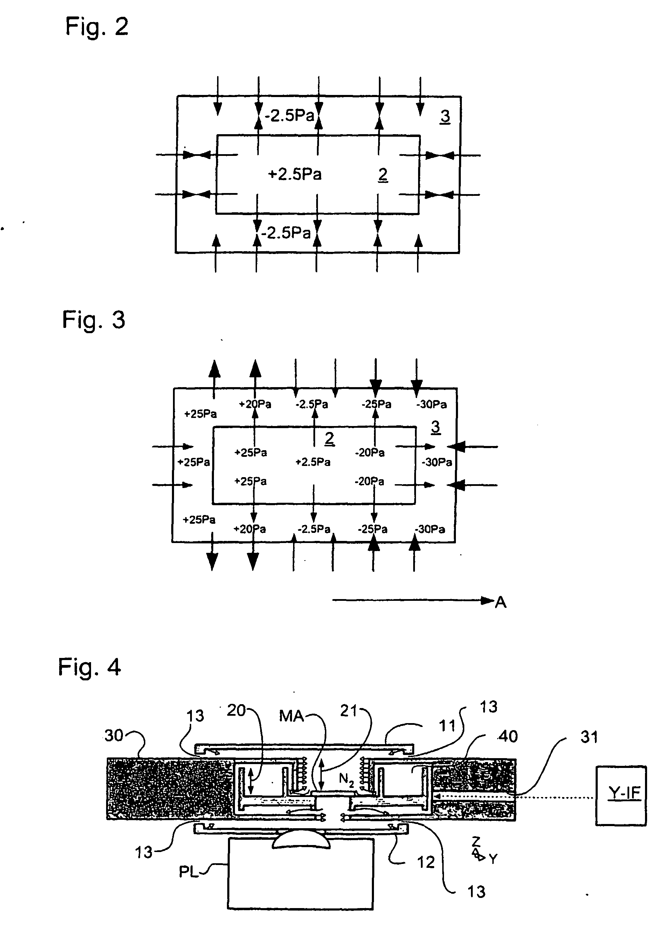

Figures 2 and 3 illustrate the principle of the purge compartment of the present invention. The inner purge compartment 2 is surrounded at least partially by an outer compartment 3, which may be regarded as a "moat". Relative to the remainder of the apparatus, which has a certain pressure but is shown as being at a pressure of 0Pa, the inner purge compartment 2 is maintained at an average overpressure of, for example, +2.5Pa whilst the outer purge compartment 3 is maintained at an average under pressure of, for example, -2.5Pa. This can be achieved by arranging for the supply of purge gas to be directed into the inner purge compartment 2 and for the exhaust to be taken from the outer purge compartment 3. With this arrangement, any leakage between the inner and outer purge compartment will flow from the inner to the outer purge compartment whilst any leakage of air from the exterior to the outer purge compartment will be prevented from reaching the inner purge compartment. Note that the "exterior" in this context may be the interior of a cabinet of the lithographic apparatus or the clean room in which the apparatus is located.

When the purge compartments are at rest, the pressures in the inner and outer purge compartments will be uniform, as shown in Figure 2. Acceleration however causes pressure variations within the moving compartments, as shown in Figure 3 which illustrates the case where the purge compartments are accelerating in the direction indicated by the arrow A. When the purge compartments are accelerating, there will be a local decrease, possibly of 25Pa or more, in pressure at the leading side of the moving compartments and a local increase, also possibly of 25Pa or more, at the trailing side. However, the present invention prevents the local pressure drop from resulting in leakage into the inner compartment because the pressure changes in the inner and outer purge compartments 2,3 will be substantially the same. Thus the pressure differential between inner and outer purge compartments 2,3 is maintained locally even when the local pressure variations within the compartments are much greater than the pressure differential. The drop in pressure at the leading side of the outer purge compartment is likely to lead to the outer compartment being locally at a lower pressure that the exterior so that there may be local leakage into the outer purge compartment 3. However, the resultant contamination is exhausted from the outer purge compartment and does not reach the inner purge compartment 2.

Figure 4 shows how the inner and outer purge compartments are incorporated into the mask stage of the apparatus of Figure 1, however it will be appreciated that the present invention may also be implemented in the substrate stage(s) or around any other moving part of the lithographic apparatus.

As shown in Figure 4, the short-stroke frame 30 of the mask stage forms a partially-open, moving purge-box which is closed by fixed supply and exhaust bins 11, 12 and surrounds the chuck 40. The short-stroke frame 30 is driven to scan by a long-stroke drive (not shown) whilst the chuck 40 is supported from the short-stroke frame 30 by vertical actuators (not shown) and makes small movements in all degrees of freedom. The upper exhaust bin 11 is fixed with respect to the illumination system IL and provides purge gas to the inner compartment above the mask MA. This gas flows outwardly past restrictions between the short-stroke frame 30 and chuck 40 and is exhausted upwardly from above the sides of the chuck 40 by exhausts (not shown). Lower exhaust bin 12 is similarly fixed relative to projection lens PL and exhausts gas from around the first element of the projection system PL so as to purge the space below the mask MA.

The partially-open box provided by the short-stroke frame 30 leaves one side of the chuck 40 free so that it can be measured directly by the beams from the X-interferometer (not shown) and a bore 31 is provided in one side of the short-stroke frame 30 to allow the beam from the Y-interferometer Y-IF through to the chuck 40.

Since the short-stroke frame 30 will move relative to the upper and lower supply and exhaust bins 11, 12, gas bearings 13 are provided in the upper and lower supply and exhaust bins 11, 12. The gas bearings 13 can be pre-stressed by a pressure differential between ambient air and the inner purge compartment, magnetically, by additional vacuum areas or using additional mass, for example.

As can be seen in Figure 4, the inner purge compartment 2 surrounds the mask MA and is itself surrounded by the outer purge compartment 3 which is formed as a channel in the chuck 40. The pressure in the outer purge compartment is kept lower than that of the inner purge compartment by the exhausts which are located above it. So that the pressure variations in the outer compartment are as close as possible to those in the inner compartment, the depth 20 of the channel forming the outer compartment 3 is made to be as close as possible to the depth 21 of the well forming the inner compartment 2. It should be borne in mind that whilst only a single outer compartment is shown in Figure 4, a plurality of concentric channels can be provided to form a plurality of nested outer compartments. Such an arrangement would provide additional protection against contamination. Preferably the outermost of any such plurality of second compartments would have the lowest pressure, with pressure increasing towards the inner compartment. It should also be noted that not all of the nested second compartments need have a pressure lower than the exterior but all should have a pressure lower than the first compartment.

Whilst specific embodiments of the invention have been described above, it will be appreciated that the invention may be practiced otherwise than as described. The description is not intended to limit the invention, which is defined by the claims.

## Claims

1. A lithographic projection apparatus comprising:

   - a radiation system for providing a projection beam of radiation;
   - a support structure for supporting patterning means, the patterning means serving to pattern the projection beam according to a desired pattern;

- a substrate table for holding a substrate;
- a projection system for projecting the patterned beam onto a target portion of the substrate; and
a first compartment (2) containing and arranged to move with a moveable component (MT) of said apparatus, said first compartment enclosing said movable component in at least a plane containing a direction of movement of said moveable component.

**characterized by**:

a second compartment (3) containing and arranged to move with said first compartment (2), said second compartment enclosing said first compartment in at least a plane containing the direction of movement of said moveable component; and
a purge gas system for supplying purge gas to said first compartment and removing purge gas from said second compartment such that said first compartment is, in use, at an average pressure $P_1$, said second compartment is, in use, at an average pressure $P_2$, whereby the pressures $P_1$, $P_2$ satisfy the inequalities:
$P_1 > P_0$ and $P_2 < P_0$
where $P_0$ is the pressure of the environment exterior to the second compartment.

2. An apparatus according to claim 1 wherein the depth of said second compartment (3) is in a direction perpendicular to the direction of movement of said moveable component substantially equal to the depth in said direction of said first compartment (2).

3. An apparatus according to claim 1 or 2 comprising a plurality of second compartments (3) nested about said first compartment (2).

4. An apparatus according to claim 3 wherein the outermost of said plurality of second compartments is, in use, at the lowest pressure.

5. An apparatus according to any one of claims 1 to 4 wherein said moveable component is said substrate table (WT).

6. An apparatus according to any one of claims 1 to 4 wherein said moveable component is said support structure (MT).

7. An apparatus according to any one of the preceding claims, wherein the support structure comprises a mask table (MT) for holding a mask (MA).

8. An apparatus according to any one of the preceding claims, wherein the radiation system (IL) comprises a radiation source (LA).

9. A device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material;
providing a first compartment (2) containing and arranged to move with a moveable component (MT) of said apparatus, said first compartment enclosing said movable component in at least a plane containing a direction of movement of said moveable component.

**characterized by**:

a second compartment (3) containing and arranged to move with said first compartment (2), said second compartment enclosing said first compartment in at least a plane containing the direction of movement of said moveable component; and
supplying purge gas to said first compartment and removing purge gas from said second compartment such that said first compartment is at an average pressure $P_1$ and said second compartment is at an average pressure $P_2$; whereby said pressures $P_1$, $P_2$ satisfy the inequalities

$$P_1 > P_0 \text{ and } P_2 < P_0$$

where $P_0$ is the average pressure of the environment exterior to said second compartment.

**Patentansprüche**

1. Ein lithographischer Projektionsapparat folgendes aufweisend:

- ein Strahlungssystem zur Bereitstellung eines Projektionsstrahls;
- eine Abstützstruktur zur Abstützung von Musterungsmitteln, welche dazu dienen, den Projektionsstrahl gemäß einem gewünschten Muster zu mustern;
- einen Substrattisch zum Halten eines Substrats;
- ein Projektionssystem zum Projizieren des gemusterten Strahls auf einen Zielabschnitt des Substrates; und

ein erstes Fach (2), welches angeordnet ist, mit einer beweglichen Komponente (MT) der Vorrichtung sich zu bewegen und diese enthält, wobei das genannte erste Fach die genannte bewegliche Komponente in zumindest einer Ebene umschließt, die eine Bewegungsrichtung der genannten beweglichen Komponente enthält,

**gekennzeichnet durch**

ein zweites Fach (3), welches angeordnet ist, um sich mit dem ersten Fach (2) zu bewegen und welches dieses enthält, wobei das genannte zweite Fach das genannte erste Fach in zumindest einer Ebene umschließt, welche die Bewegungsrichtung der genannten beweglichen Komponente enthält; und

ein Reinigungsgassystem zum Zuführen eines Reinigungsgases zum genannten ersten Fach und zum Entfernen von Reinigungsgas aus dem genannten zweiten Fach, derart, dass das genannte erste Fach im Betrieb einen mittleren Druck $P_1$ hat, während das zweite Fach im Betrieb einen mittleren Druck $P_2$ hat, und wobei die Drücke $P_1$, $P_2$ die folgenden Relationen haben:

$P_1 > P_0$ und $P_2 < P_0$ wobei $P_0$ der Druck in der Umgebung außerhalb des zweiten Faches ist.

2. Vorrichtung nach Anspruch 1, wobei die Tiefe des genannten zweiten Faches (3) in einer Richtung senkrecht zur Bewegungsrichtung der genannten beweglichen Komponenten im Wesentlichen gleich ist der Tiefe des genannten ersten Faches (2) in der genannten Richtung.

3. Vorrichtung gemäß einem der Ansprüche 1 oder 2 mit einer Mehrzahl zweiter Fächer (3), die um das genannte erste Fach (3) geschachtelt sind.

4. Vorrichtung nach Anspruch 3, wobei das äußerste der genannten Mehrzahl zweiter Fächer im Betrieb den kleinsten Druck hat.

5. Vorrichtung gemäß einem der Ansprüche 1 bis 4, wobei die genannte bewegliche Komponente der genannte Substrattisch (WT) ist.

6. Vorrichtung nach einem der Ansprüche 1 bis 4, wobei die genannte bewegliche Komponente die genannte Stützstruktur (MT) ist.

7. Vorrichtung gemäß einem der vorhergehenden Ansprüche, wobei die genannte Stützstruktur einen Maskentisch (MT) zum Halten einer Maske (MA) aufweist.

8. Vorrichtung gemäß einem der vorhergehenden Ansprüche, wobei das Strahlungssystem (IL) eine Strahlungsquelle (LA) aufweist.

9. Verfahren zur Produktherstellung, folgende Schritte aufweisend:

- Bereitstellen eines Substrates, das zumindest teilweise durch eine Schicht aus strahlungsempfindlichem Material abgedeckt ist;
- Bereitstellen eines Projektionsstrahls aus Strahlung unter Verwendung eines Strahlungssystems;
- Verwendung einer Musterungseinrichtung, um den Projektionsstrahl über seinen Querschnitt mit einem Muster zu versehen;
- Projizieren des gemusterten Strahls aus Strahlung auf einen Zielabschnitt der Schicht aus strahlungsempfindlichem Material;
- Bereitstellen eines ersten Fachs (2) welches angeordnet ist, um mit einer bewegbaren Komponenten (MT) der Vorrichtung sich zu Bewegen und diese zu enthalten, wobei das genannte erste Fach die genannte bewegbare Komponente in zumindest einer Ebene, welche die Bewegungsrichtung der genannten bewegbaren Komponenten enthält, umschließt,

**gekennzeichnet durch**:

ein zweites Fach (3), welches angeordnet ist, um sich mit dem genannten ersten Fach (2) zu bewegen und welches dieses enthält, wobei das genannte zweite Fach das genannte erste Fach in zumindest einer Ebene umfängt, die die Bewegungsrichtung der genannten bewegbaren Komponente enthält; und

Einbringen eines Reinigungsgases in das genannte erste Fach und Entfernen von Reinigungsgas aus dem genannten zweiten Fach derart, dass das genannte erste Fach einen mittleren Druck $P_1$ hat und das genannte zweite Fach einen mittleren Druck $P_2$ hat, wobei die genannten Drücke $P_1$, $P_2$ die folgenden Ungleichungen erfüllen:

$P_1 > P_0$ und $P_2 < P_0$

wobei $P_0$ der mittlere Druck der Umgebung außerhalb des genannten zweiten Faches ist.

**Revendications**

1. Appareil de projection lithographique comprenant :

- un système de rayonnement pour délivrer un faisceau de projection de rayonnement ;
- une structure de support pour supporter des moyens de mise en forme, les moyens de mise en forme servant à mettre en forme le faisceau de projection conformément à un motif voulu ;
- une table de substrat pour supporter un substrat ;
- un système de projection pour projeter le faisceau mis en forme sur une partie cible du substrat ; et
- un premier compartiment (2) contenant un composant mobile (MT) dudit appareil et agencé pour se déplacer avec celui-ci, ledit premier compartiment enfermant ledit composant mobile dans au moins un plan contenant une direction de déplacement dudit composant mobile ;

**caractérisé par** :

un second compartiment (3) contenant ledit premier compartiment (2) et agencé pour se déplacer avec celui-ci, ledit second compartiment enfermant ledit premier compartiment dans au moins un plan contenant la direction de déplacement dudit composant mobile ; et
un système de gaz de purge pour fournir du gaz de purge audit premier compartiment et pour retirer du gaz du purge dudit second compartiment de telle sorte que ledit premier compartiment est, en utilisation, à une pression moyenne $P_1$, ledit second compartiment est, en utilisation, à une pression moyenne $P_2$, les pressions $P_1$, $P_2$ satisfaisant aux inégalités :
$P_1 > P_0$ et $P_2 < P_0$

où $P_0$ est la pression de l'environnement extérieur au second compartiment.

2. Appareil selon la revendication 1 dans lequel la profondeur dudit second compartiment (3) est, dans une direction perpendiculaire à la direction de déplacement dudit composant mobile, sensiblement égale à la profondeur dans ladite direction dudit premier compartiment (2).

3. Appareil selon la revendication 1 ou 2 comprenant une pluralité de seconds compartiments (3) emboîtés autour dudit premier compartiment (2).

4. Appareil selon la revendication 3 dans lequel le plus à l'extérieur parmi ladite pluralité de seconds compartiments est, en utilisation, à la pression la plus basse.

5. Appareil selon l'une quelconque des revendications 1 à 4 dans lequel ledit composant mobile est ladite table de substrat (WT).

6. Appareil selon l'une quelconque des revendications 1 à 4 dans lequel ledit composant mobile est ladite structure de support (MT).

7. Appareil selon l'une quelconque des revendications précédentes, dans lequel la structure de support comprend une table de masque (MT) pour supporter un masque (MA).

8. Appareil selon l'une quelconque des revendications précédentes, dans lequel le système de rayonnement (IL) comprend une source de rayonnement (LA).

9. Procédé de fabrication de dispositif comprenant les étapes suivantes:

- fournir un substrat qui est au moins partiellement recouvert d'une couche de matériau sensible au rayonnement ;
- fournir un faisceau de projection de rayonnement en utilisant un système de rayonnement ;
- utiliser des moyens de mise en forme pour doter le faisceau de projection d'un motif dans sa section transversale ;
- projeter le faisceau de rayonnement mis en forme sur une partie cible de la couche de matériau sensible au rayonnement ;
- fournir un premier compartiment (2) contenant un composant mobile (MT) dudit appareil et agencé pour se déplacer avec celui-ci, ledit premier compartiment enfermant ledit composant mobile dans au moins un plan contenant une direction de déplacement dudit composant mobile ;

**caractérisé par :**

un second compartiment (3) contenant ledit premier compartiment (2) et agencé pour se déplacer avec celui-ci, ledit second compartiment enfermant ledit premier compartiment dans au moins un plan contenant la direction de déplacement dudit composant mobile ; et
la fourniture d'un gaz de purge audit premier compartiment et le retrait du gaz du purge dudit second compartiment de telle sorte que ledit premier compartiment est à une pression moyenne $P_1$ et ledit second compartiment est à une pression moyenne $P_2$ ; lesdites pressions $P_1$, $P_2$ satisfaisant aux inégalités :
$P_1 > P_0$ et $P_2 < P_0$

où $P_0$ est la pression moyenne de l'environnement extérieur audit second compartiment.

Fig. 1

## Fig. 2

## Fig. 3

## Fig. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- WO 9838597 A
- WO 9833096 A
- US 5229872 A
- US 6046792 A
- US 5969441 A
- WO 9840791 A
- EP 1172698 A
- WO 9957607 A
- EP 1052551 A2
- EP 0532968 A1
- EP 1098225 A

**Non-patent literature cited in the description**

- **PETER VAN ZANT.** Microchip Fabrication: A Practical Guide to Semiconductor Processing. McGraw Hill Publishing Co, 1997